# EUROPEAN PATENT SPECIFICATION

(11) **EP 4 131 345 B1**
(45) Date of publication and mention of the grant of the patent: **23.10.2024**
(21) Application number: 21780361.8
(22) Date of filing: 29.03.2021
(51) Int. Cl.: H01L 21/308, H05K 3/06, H01L 21/48

(54) **CERAMIC CIRCUIT BOARD WITH RESIST CURED FILM, MANUFACTURING METHOD THEREFOR, AND CERAMIC CIRCUIT BOARD MANUFACTURING METHOD**
KERAMISCHE LEITERPLATTE MIT GEHÄRTETEM RESISTFILM, HERSTELLUNGSVERFAHREN DAFÜR UND HERSTELLUNGSVERFAHREN FÜR KERAMISCHE LEITERPLATTE
CARTE DE CIRCUIT IMPRIMÉ EN CÉRAMIQUE À FILM DURCI DE RÉSERVE, SON PROCÉDÉ DE FABRICATION ET PROCÉDÉ DE FABRICATION DE CARTE DE CIRCUIT IMPRIMÉ EN CÉRAMIQUE

(30) Priority: 30.03.2020 JP 2020060208
(43) Date of publication of application: 08.02.2023
(73) Proprietor: Denka Company Limited, Tokyo 103-8338 (JP)
(72) Inventor: YUASA, Akimasa, Tokyo 103-8338 (JP); NAKAMURA, Takahiro, Tokyo 103-8338 (JP); NISHIMURA, Koji, Tokyo 103-8338 (JP)
(74) Representative: Zacco Sweden AB
(86) International application number: PCT/JP2021/013261
(87) International publication number: WO 2021/200810

(56) References cited:
- EP-A1- 2 916 627
- WO-A1-2011/034075
- WO-A1-2015/029478
- JP-A- 2013 084 822
- JP-A- H 098 436
- JP-A- H05 163 077
- JP-A- H06 228 774
- JP-A- H1 129 371
- US-A1- 2008 158 278

## Description

### Technical Field

The present invention relates to a ceramic circuit board with a resist cured film and a method for producing a ceramic circuit board.

### Background Art

Ceramic circuit boards have been conventionally used as mounting boards for power devices generating high-temperature heat, such as power modules, power transistors and the like for elevators, vehicles, hybrid cars and the like. The ceramic circuit boards are obtained by bonding a metal having electroconductivity, such as copper or aluminum, on a ceramic substrate by a direct bonding method or an active metal bonding method in which bonding is carried out with a brazing material containing an active metal, applying a resist to the metal having electroconductivity after the bonding along a predetermined circuit pattern, etching the portions excluding a resist pattern, and as required, removing the resist (Patent Document 1).

Known methods of forming a resist pattern include a photolithography process, a screen printing process, and an inkjet printing process. In the photolithography method, a resist pattern is formed by an exposure step of partially irradiating a resist ink (resist material) called a photoresist with light through a mask to make the solubility of the resist to be varied, and thereafter, by a development step of removing unnecessary resist with a chemical. In the screen printing process, a resist pattern is formed by applying a resist ink on a metal and irradiating the resist ink with light to make the solubility of the resist to be varied. In the inkjet printing process, a resist pattern is formed by applying a resist ink along a pattern on a metal, and curing the resist ink. Patent document 2 discloses a method for producing a ceramic circuit board used for power modules involving printing a resist in a circuit pattern on the metal sheet; and removing unnecessary metal sheet portions covered with no resist by etching.

### Citation List

### Patent Document

Patent Document 1: Japanese Patent Laid-Open No. 10-70212
Patent Document 2: European patent application publication EP2916627

### Summary of Invention

### Technical Problem

In the photolithography process, however, there are needed many steps including an exposure step and a development step in photolithography, so the production efficiency of ceramic circuit boards is low. Further in the production process, a brazing material in bonding squeezes out from edges of a composite of a ceramic and copper and makes level differences in some cases. In this case, another problem is that a resist pattern cannot be formed on the edges of the composite.

Also in the screen printing process, a form plate along a pattern needs to be previously fabricated, resulting in low production efficiency of ceramic circuit boards. Further, another problem is that fine regulation is needed in sizing the form plate, which requires a long time for fabrication of the form plate.

Further, the resist ink to be used in the inkjet printing process usually has low resistance to etching solutions. Hence, it is difficult to form high-precision resist patterns by the inkjet printing process.

The present invention has been made in consideration of such problems, and an object is to provide a method for producing a ceramic circuit board with a resist cured film by using an inkjet device, which can efficiently produce the ceramic circuit board with a resist cured film having a resist pattern high in resistance to an etching solution and high in precision, and a ceramic circuit board with a resist cured film obtained by the production method, and a method for producing a ceramic circuit board.

### Solution to Problem

As a result of exhaustive studies to achieve the above object, the present inventors have found that a method for producing a ceramic circuit board with a resist cured film using an inkjet printing process, by including a step of forming a specific multilayer resist cured film, can solve the above problems, and this finding has led to the completion of the present invention.

That is, the present invention is according to claims 1-3.

### Advantageous Effects of Invention

According to the present invention, there can be provided a method for producing a ceramic circuit board with a resist cured film by using an inkjet device, which can efficiently produce the ceramic circuit board with a resist cured film having a resist pattern high in resistance to an etching solution and high in precision, and a ceramic circuit board with a resist cured film obtained by the production method.

### Description of Embodiment

Hereinafter, an embodiment (hereinafter, referred to simply as "the present embodiment") to carry out the present invention will be described in detail. Then, the following present embodiment is exemplifications in order to interpret the present invention, and the present invention is not limited only to the present embodiment.

### [Ceramic circuit board with a resist cured film]

A ceramic circuit board with a resist cured film according to the present embodiment contains a metal-ceramic bonded body (hereinafter, referred to also simply as "bonded body") having a ceramic substrate, a layer containing titanium nitride (hereinafter, referred to also simply as "titanium nitride layer"), a brazing material layer containing silver (hereinafter, referred to also simply as "brazing material layer"), and a metal plate having electroconductivity (hereinafter, referred to also simply as "metal plate") stacked in this order, and a multilayer resist cured film (hereinafter, referred to also simply as "multilayer resist film") printed on the metal plate, wherein at least the metal plate and the multilayer resist film have a predetermined circuit pattern; and the uniformity of the thickness of the multilayer resist film is 20% or lower. Since the ceramic circuit board with a resist cured film according to the present embodiment has a resist pattern high in resistance to an etching solution and high in precision, by using the ceramic circuit board, the size reduction of circuit boards can be attained. Further since the ceramic substrate is used, the output enhancement of power modules can be attained.

The multilayer resist film according to the present embodiment has the multilayer resist cured film having a uniform thickness, whose uniformity is 20% or lower, preferably 17% or lower and more preferably 14% or lower. The lower limit is not especially limited, and is usually 1% or higher. When the uniformity of the thickness of the multilayer resist film is in the above range, an effect of being capable of accurately forming circuit patterns can be attained. In the multilayer resist film obtained by an inkjet printing process in the present embodiment, the thickness of the multilayer resist film is uniform as compared with that of resist cured films obtained by a photolithography process and a screen printing process. Then, in the present embodiment, the uniformity of the thickness of the multilayer resist film is measured by a method described in Examples.

Examples of the ceramic substrate according to the present embodiment include nitride-based ceramics such as silicon nitride and aluminum nitride, oxide-based ceramics such as aluminum oxide and zirconium oxide, carbide-based ceramics such as silicon carbide, and boride-based ceramics such as lanthanum boride. Among these, from the viewpoint of the thermoconductivity, the safety, the cost and the like, nitride-based ceramics and oxide-based ceramics are preferable; and from the viewpoint of having better thermoconductivity, heat dissipation characteristic and electric insulation, nitride-based ceramics are more preferable. Since nitride-based ceramics have better thermoconductivity and electric insulation, by using this ceramic substrate, the size reduction of circuit boards and the output enhancement of power modules can be attained.

The thickness of the ceramic substrate is, from the viewpoint of providing suitable durability and thermal resistance, preferably 0.2 mm or larger and 1.5 mm or smaller.

The titanium nitride layer according to the present embodiment is not especially limited as long as it contains titanium nitride. The titanium nitride layer according to the present embodiment is obtained by applying a brazing material containing silver and titanium described later to the ceramic substrate and bonding a metal plate with the ceramic substrate.

The thickness of the titanium nitride layer is not especially limited, and is usually 0.2 µm or larger and 2.0 µm or smaller.

Examples of the metal plate according to the present embodiment include gold, silver, copper, aluminum, and alloys thereof, and two-layer clad materials containing these metals. Among these, from the viewpoint of providing excellent electroconductivity and thermoconductivity, preferable are copper, aluminum, and two-layer clad materials of copper and aluminum. Examples of the copper plate include oxygen-free copper plates.

The thickness of the metal plate is not especially limited, and is usually 0.1 mm or larger and 1.5 mm or smaller. By making the thickness of the metal plate to be in the above range, also in use as circuit boards for power modules, sufficient electroconductivity can be secured and problems such as heat generation of the metal plate are suppressed.

The multilayer resist film according to the present embodiment is not especially limited as long as a plurality of single-layer resist films made by curing a resist ink described later are layered. Because of having such a multilayer resist film, a resist pattern high in resistance to an etching solution and high in precision can be formed.

The thickness of the multilayer resist film is, because of being capable of making the resistance to an etching solution higher, 30 µm or larger. The upper limit of the thickness of the multilayer resist film, since residues of the multilayer resist film are unlikely to be formed in stripping thereof, is 50 µm or smaller. Then, the number of layers of the multilayer resist film is, because of being capable of making the resistance to an etching solution higher and being excellent in the removability, preferably two to three layers and more preferably three layers.

In the ceramic circuit board with a resist cured film according to the present embodiment, at least the metal plate and the multilayer resist film have a predetermined circuit pattern. Here, the predetermined circuit pattern refers, for example, to a circuit pattern constituted of a wiring pattern having a predetermined shape, capacitors and inductances in a mounting board.

The ceramic circuit board with a resist cured film according to the present embodiment has the brazing material layer containing silver between the titanium nitride layer and the metal plate. Because of containing the brazing material layer, the titanium nitride layer and the metal plate are firmly bonded.

The brazing material layer, since it is necessary to ensure high bondability and heat cycle characteristic, contains silver. The amount of silver contained in the brazing material layer is not especially limited, and is, with respect to 100% by mass of the brazing material layer, usually 50 parts by mass or larger and 100 parts by mass or smaller.

The thickness of the brazing material layer is not especially limited, and is usually 3 µm or larger and 25 µm or smaller.

[Method for producing a ceramic circuit board with a resist cured film]

A method for producing a ceramic circuit board with a resist cured film having a predetermined circuit pattern according to the present embodiment contains:
a step of providing a bonded body having a ceramic substrate, a titanium nitride layer, a brazing material layer and a metal plate stacked in this order;
a step of applying a resist ink along the circuit pattern on the metal plate by an inkjet printing process, followed by curing to form a single-layer resist cured film, and repeating the formation a plurality of times to thereby form a multilayer resist film; and
a step of etching the titanium nitride layer, the brazing material layer and the metal plate excluding the portions thereof present underneath the multilayer resist film by using an etching solution.

According to the method for producing a ceramic circuit board with a resist cured film according to the present embodiment, there can efficiently be produced the ceramic circuit board with a resist cured film having a resist pattern high in resistance to the etching solution and high in precision.

### (Step of providing a metal-ceramic bonded body)

The present embodiment contains the step of providing a bonded body having a ceramic substrate, a titanium nitride layer, a brazing material layer and a metal plate stacked in this order. The ceramic substrate, the titanium nitride layer, the brazing material layer and the metal plate are as described above.

The bonded body according to the present embodiment can be produced by a well-known method, and can be produced, for example, by an active metal bonding method in which bonding is carried out with a brazing material containing titanium as an active metal. Further, the bonded body according to the present embodiment, as required, may be produced by concurrently using a direct bonding method in which the metal plate is disposed directly on the ceramic substrate, and heated in an inert atmosphere.

In the case of using the active metal bonding method, the bonded body according to the present embodiment can be produced, for example, as follows. That is, a pasty brazing material is applied uniformly on the surface of the ceramic substrate by a method such as a roll coater process, a screen printing process or a transfer process, and the metal plate is bonded to the surface of the brazing material. It is preferable that a method of applying the brazing material is a screen printing process, from the viewpoint of being capable of uniform application thereof. Then, the metal plate may be bonded so as to have a predetermined circuit pattern.

The brazing material according to the present embodiment contains silver and titanium, from the viewpoint of being capable of more firmly bonding the ceramic substrate and the metal plate. Due to bonding of the brazing material with the ceramic substrate, a titanium nitride layer is formed on the ceramic substrate. Then, a brazing material layer is formed on the titanium nitride layer and the titanium nitride layer is bonded with the metal plate through the brazing material layer.

The ratio of contents of silver and titanium contained in the brazing material is not especially limited, and the content of titanium is, with respect to 100 parts by mass of silver, usually 1.0 part by mass or higher and 5.0 parts by mass or lower.

The brazing material may contain a well-known binder such as a polyisobutyl methacrylate. The amount of the binder in the brazing material is preferably 2% by mass or larger and 8% by mass or smaller.

The brazing material may contain a well-known organic solvent such as terpineol. The amount of the organic solvent in the brazing material is, from the viewpoint of being capable of more uniform application thereof, 5% by mass or larger and 30% by mass or smaller.

The viscosity of the brazing material is, from the viewpoint of being capable of more uniform application thereof, preferably 3 Pa·s or higher and 20 Pa·s or lower (temperature: 20°C or higher and 25°C or lower).

Examples of a bonding method include a method of obtaining the bonded body by stacking the metal plate on the brazing material surface of the ceramic substrate having the brazing material applied thereon, and thereafter heating the resultant in a heating furnace to sufficiently bond the ceramic substrate and the metal plate. In this case, the heating temperature is, for example, 700°C or higher and 900°C or lower. The atmosphere in the heating furnace is not especially limited, and may be inert gas such as nitrogen and may be in a reduced pressure of lower than the atmospheric pressure. The atmosphere may be in vacuum. The heating furnace may be a continuous-type one in which a plurality of the bonded bodies are continuously produced, or may be one in which one bonded body or a plurality of the bonded bodies are produced in a batch type. The heating may be carried out while the bonded body is pressed in the stacking direction.

The bonded body according to the present embodiment, as required, may be subjected to a plating treatment on the metal plate, such as nickel plating, nickel alloy plating, gold plating or silver plating, and a rustproof treatment.

Then, the "step of providing a metal-ceramic bonded body" may also be a step of simply procuring (obtaining) a bonded body produced by a well-known method.

### (Step of forming a multilayer resist cured film)

The multilayer resist film can be obtained by applying a resist ink along a circuit pattern on the surface of the metal plate by an inkjet printing process, followed by curing to form a single-layer resist cured film, and thereafter, further similarly forming one layer or two or more layers of the single-layer resist cured film on the resultant single-layer resist cured film. The number of repetition of the formation of the single-layer resist cured film is, from the viewpoint of being capable of more enhancing the resistance to the etching solution, preferably twice or more and three times or less, and more preferably three times. The thickness of the multilayer resist film is, from the viewpoint of being capable of more enhancing the resistance to the etching solution, 30 µm or larger. The thickness of the multilayer resist film is 50 µm or smaller.

In the present embodiment, the multilayer resist film can be fabricated by a well-known method using an inkjet printing process, and can be fabricated, for example, by the following direct drawing system. In the direct drawing system, a single-layer resist cured film is formed according to a desired shape by discharging a resist ink from a nozzle of an inkjet device, and applying the resist ink on the metal plate having the desired shape, followed by curing. By repeating this, a multilayer resist film can be formed. When the desired shape is a wiring shape, a pattern-shape wiring becomes enabled to be formed. As the inkjet device, a usually commercially available inkjet applying apparatus can be used and the inkjet device is not especially limited as long as it is capable of discharging the resist ink. The inkjet device usually has an inkjet head and a nozzle, and is equipped preferably with a heating unit to raise the temperature of the inkjet device interior or the inkjet head interior to 50°C or higher.

In the direct drawing system, as the inkjet head the inkjet device has, there is, for example, a piezo-type one. In the case of the direct drawing system, the viscosity of the resist ink is, from the viewpoint of more improving the resolution, preferably 5.0 mPa·s or higher and 20.0 mPa·s or lower (temperature: 20°C or higher and 60°C or lower). In order to regulate the viscosity to such a viscosity, it is preferable that the resist ink is heated in the inkjet device, and the heating temperature is, for example, in the range of 25°C or higher and 60°C or lower.

Examples of a method of curing the single-layer resist cured film include a method in which the applied resist ink is irradiated directly or indirectly with ultraviolet rays. Examples of an irradiation source to be used for the irradiation with ultraviolet rays include chemical lamps, low-pressure mercury lamps, medium-pressure mercury lamps, high-pressure mercury lamps, extrahigh-pressure mercury lamps, xenon lamps, metal halide lamps and LED-UV lamps. Further in the curing, in addition to ultraviolet rays, electron beams or the like can also be employed, and the irradiation source is not especially limited as long as it is active energy rays having an energy quantum in a degree of being capable of polymerizing or crosslinking a molecule of a monomer or the like. In the case of using ultraviolet rays, the irradiation dose is not especially limited, and is usually 100 mJ/cm² or higher and 1,000 mJ/cm² or lower. In the present embodiment, after the resist cured film is formed, from the viewpoint of curing the resist ink more securely, the resist cured film may further be subjected to a post-curing treatment of irradiation with ultraviolet rays.

In the present embodiment, by repeating this direct drawing system a plurality of times, a multilayer resist cured layer can be formed.

The resist ink according to the present embodiment is not especially limited as long as it is a resist ink to be used in the inkjet printing process, but it is preferable that the resist ink contains (meth)acrylamide because of having excellent acid resistance. As such a resist ink containing (meth)acrylamide, a commercially available one may be used, and examples thereof include GIP-410 (trade name), manufactured by Goo Chemical Co., Ltd.

### (Etching step)

The etching step according to the present embodiment is a step of etching the titanium nitride layer, the brazing material layer and the metal plate excluding the portions thereof present underneath the multilayer resist film by using an etching solution.

The etching solution to be used in the present embodiment is not especially limited as long as it is capable of etching the titanium nitride layer, the brazing material layer and the metal plate. As the etching solution, there may also be used a solution in which corresponding etching solutions are suitably mixed so as to be capable of simultaneously etching the titanium nitride layer, the brazing material layer and the metal plate.

It is preferable that an etching solution for the titanium nitride layer is an aqueous solution containing ammonium fluoride and hydrogen peroxide, because of being capable of suitably etching the titanium nitride layer. Ammonium fluoride acts as a pH regulator. As such an etching solution, preferable is a mixed solution of an ammonium fluoride aqueous solution in 1 mol/L or higher and 20 mol/L or lower, and a 35% hydrogen peroxide aqueous solution; and more preferable is a mixed solution obtained by mixing the ammonium fluoride aqueous solution and the hydrogen peroxide aqueous solution in 1:10 to 10:1 (ammonium fluoride aqueous solution:hydrogen peroxide aqueous solution) in terms of parts by mass. The temperature of the etching solution is not especially limited, and is preferably 25°C or higher and 50°C or lower, because of being capable of effectively etching the titanium nitride layer.

Hydrogen peroxide, since it has a strong oxidizing power, forms pinholes in the resist cured film, dissolves and erodes the resist cured film and consequently forms pinholes in the circuit area in some cases. The multilayer resist film according to the present embodiment, however, since it has a structure in which a plurality of the single-layer resist cured films are stacked, is not dissolved nor eroded even if hydrogen peroxide, having a strong oxidizing power, is used. Hence, according to the production method according to the present embodiment, the ceramic circuit board with a resist cured film having a resist pattern high in resistance to the etching solution and high in precision can be obtained.

It is preferable that an etching solution for the brazing material layer is an aqueous solution containing sodium thiosulfate, because of being capable of effectively removing silver contained in the brazing material layer before the etching of the titanium nitride layer. As such an etching solution, preferable is one containing sodium thiosulfate usually in 0.1 parts by mass or higher and 40 parts by mass or lower with respect to 100 parts by mass of water. The temperature of the etching solution is not especially limited, and is preferably 30°C or higher and 50°C or lower, because of being capable of effectively etching the brazing material layer.

An etching solution for the metal plate is not especially limited, and a well-known etching solution can be used. In the case where the metal plate contains copper, the etching solution is preferably an aqueous solution containing hydrochloric acid and copper chloride, and more preferably a copper chloride aqueous solution acidified with hydrochloric acid. As such an etching solution, preferable is a mixed solution of hydrochloric acid in 1 mol/L or higher and 5 mol/L or lower and a copper (II) chloride aqueous solution in 1 mol/L or higher and 5 mol/L or lower; and more preferable is a mixed solution obtained by mixing hydrochloric acid and the copper (II) chloride aqueous solution in 1 part by mass:10 parts by mass to 10 parts by mass:1 part by mass (hydrochloric acid:copper (II) chloride aqueous solution) in terms of parts by mass. The temperature of the etching solution is not especially limited, and is preferably 40°C or higher and 60°C or lower, because of being capable of effectively etching the metal plate.

As an etching method, a well-known method can be employed, and examples thereof include the following method. In the case where the metal plate contains copper, the portions of the copper-containing metal plate covered with no multilayer resist film are removed by the aqueous solution containing hydrochloric acid and copper chloride; the portions of the brazing material layer, by the aqueous solution containing sodium thiosulfate; and the portions of the titanium nitride layer, by the aqueous solution containing ammonium fluoride and hydrogen peroxide. Thereby, there is obtained the ceramic circuit board with a resist cured film in which the metal plate has a predetermined circuit pattern.

Further in the present embodiment, it is preferable that the etching of the metal plate, the etching of the brazing material layer, and the etching of the titanium nitride layer are separately carried out. In this case, since there is no mixing of chemicals, the reuse of the chemicals is possible, so the case is economic.

### [Ceramic circuit board]

A ceramic circuit board is obtained by removing the multilayer resist film in the ceramic circuit board with a resist cured film according to the present embodiment. Since the ceramic circuit board according to the present embodiment is excellent in linearity of a circuit pattern and has the circuit pattern high in precision, by using the ceramic circuit board, the size reduction of circuit boards can be attained. Further since a ceramic substrate is used, the output enhancement of power modules can be attained.

### [Method for producing a ceramic circuit board]

A method for producing a ceramic circuit board according to the present embodiment contains, after the etching step in the method for producing a ceramic circuit board with a resist cured film according to the present embodiment, a step of removing the multilayer resist film according to the present embodiment. Since the ceramic circuit board according to the present embodiment has a circuit pattern high in precision, by using the ceramic circuit board, the size reduction of circuit boards can be attained. Further since a ceramic substrate is used, the output enhancement of power modules can be attained.

As a method of removing the multilayer resist film, a well-known method can be employed, and the multilayer resist film can be removed, for example, by being dissolved and stripped by using a resist dissolving and stripping solution.

The resist dissolving and stripping solution is, from the viewpoint of being capable of easily dissolving and stripping the film, preferably an alkali solution and more preferably an alkaline aqueous solution. As such an alkali solution, for example, a sodium hydroxide aqueous solution can be used. The concentration of sodium hydroxide in the sodium hydroxide aqueous solution is not especially limited, and is usually 0.01% or higher and 5% or lower and more preferably 0.5% or higher and 3% or lower. Then, as the alkali solution, there may be used an organic solvent containing an alkaline component, or an alkaline aqueous solution containing an organic solvent.

As a method of dissolving and stripping, there can be used, for example, a dipping method, a method of dissolving and stripping by spray application, and a method of irradiation with ultrasonic waves or the like after dipping. In the case of carrying out dissolving and stripping by the dipping method, it suffices if the film is dipped in the resist dissolving and stripping solution, for example, at 20°C or higher and 60°C or lower, and usually for 30 sec or longer and 10 min or shorter. This operation may be carried out only once, or may be carried out a plurality of times.

In the present embodiment, by removing the multilayer resist film, the ceramic circuit board having a predetermined circuit pattern can be obtained.

### [Semiconductor module substrate]

A semiconductor module substrate is obtained by mounting semiconductor elements on predetermined positions of a circuit in the ceramic circuit board according to the present embodiment. By using the ceramic circuit board according to the present embodiment, the semiconductor module substrate can attain the size reduction of circuit boards and the output enhancement of power modules.

### Examples

Hereinafter, the present invention will be described in detail by way of Examples and Comparative Example, but the present invention is not any more limited to these Examples.

### [Evaluation methods]

### (1) The thickness of the resist cured film and the uniformity thereof

The difference in thickness between a circuit pattern and a multilayer resist cured film or a single-layer resist cured film in a ceramic circuit board with a resist cured film obtained in each of the Examples and the Comparative Example was measured by using a contact-type contour meter (Contourrecord 2600G (trade name), manufactured by Tokyo Seiki Kosakusho Co., Ltd.), and the difference was taken as a thickness (unit: µm) of the resist cured film. The respective results are shown in Table 1.

Then, by the same method, the maximum thicknesses and the minimum thicknesses of the circuit pattern and the multilayer resist cured film or the single-layer resist cured film were measured, and by using these values, the average value of thicknesses of the resist cured film was determined. Then, the value (%) of the standard deviation to the average value, that is, (standard deviation/average value) × 100 (%), was calculated. Then, in the case where the value (%) of the standard deviation to the average value was 20% or lower, the resist cured film was regarded as being uniform, and rated as "AA"; and in the case where the value was higher than 20%, the resist cured film was regarded as being nonuniform, and rated as "CC." The respective results are shown in Table 1.

### (2) Resistance to an etching solution

For a ceramic circuit board obtained in each of the Examples and the Comparative Example, four visual fields were separately observed at a magnification of 250 times by an optical microscope, and for each visual field, whether or not pinholes were generated on the surface of the circuit pattern was visually checked and the resistance to an etching solution was evaluated according to the following criteria. The respective results are shown in Table 1.

AA: in all the four visual fields, no pinhole was generated on the surface of the circuit pattern.

CC: in any one or more visual fields out of the four visual fields, pinholes were generated on the surface of the circuit pattern.

Pinholes were generated by penetration of the etching solution (hydrogen peroxide) through the resist cured film.

### (3) Linearity of the circuit pattern

For a ceramic circuit board obtained in each of the Examples and the Comparative Example, in a visual field, the shape of unevenness generated along on the lateral side surface (one side only) of a circuit pattern was observed in the stacking direction at a magnification of 200 times by an optical microscope, and the difference Δ between the deepest recess portion and the highest raised portion of the unevenness was measured. The measurement was carried out separately in four visual fields, and for each visual field, the difference Δ was measured. By using the respective differences Δ obtained in the four visual fields, the linearity was evaluated according to the following criteria. The respective results are shown in Table 1.

AA: in all the four visual fields, the circuit pattern had the difference Δ of smaller than 25 µm.

CC: in any one or more visual fields out of the four visual fields, the circuit pattern had the difference Δ of 25 µm or larger.

### (4) Removability of the resist cured film

For a ceramic circuit board obtained in each of the Examples and the Comparative Example, four visual fields were separately observed at a magnification of 200 times by an optical microscope, and for each visual field, whether or not the resist cured film remained on the surface of the ceramic circuit board was visually checked and the removability of the resist cured film was evaluated according to the following criteria. The respective results are shown in Table 1.

AA: in all the four visual fields, it was confirmed that no resist cured film remained.

CC: in any one or more visual fields out of the four visual fields, it was confirmed that some of the resist cured film remained.

### (5) Overall judgment

For the Examples and the Comparative Example, by using the evaluation results of the uniformity of the resist cured film, the resistance to an etching solution, the linearity of the circuit pattern and the removability of the resist cured film, the overall judgment was carried out according to the following criteria. The respective results are shown in Table 1.

AA: in all of the uniformity of the resist cured film, the linearity of the circuit pattern, the resistance to an etching solution and the removability of the resist cured film, the judgment was AA.

BB: in any one or more of the uniformity of the resist cured film, the linearity of the circuit pattern, the resistance to an etching solution and the removability of the resist cured film, the judgment was not AA.

CC: in any two or more of the uniformity of the resist cured film, the linearity of the circuit pattern, the resistance to an etching solution and the removability of the resist cured film, the judgment was not AA.

### [Example 1]

### (Fabrication of a ceramic circuit board with a resist cured film)

A metal-ceramic bonded body was fabricated as follows by the active metal bonding method.

A brazing material containing silver, titanium, polyisobutyl methacrylate (PiBMA) and terpineol (organic solvent) (manufactured by Denka Co., Ltd., with respect to 100 parts by mass of silver, amount of titanium: 3.5 parts by mass, amount of the binder in the brazing material: 7 parts by mass, amount of the organic solvent in the brazing material: 20 parts by mass; viscosity: 5 Pa·s (temperature: 20°C or higher and 25°C or lower)) was applied uniformly on one surface of an aluminum nitride substrate (Denka AN Plate (trade name, 150 W/mK), manufactured by Denka Co., Ltd., thickness: 1 mm) by using a screen printing machine (manufactured by Nippon Bunkaseiko Co., Ltd.). Thereafter, a copper plate (oxygen-free copper C1020 (general grade), thickness: 0.3 mm) was stacked on the brazing material surface, and thereafter heated in a continuous-type heating furnace in a vacuum atmosphere of 1.0 × 10⁻⁴ Pa at a temperature of 820°C to sufficiently bond the ceramic substrate and the metal plate to thereby obtain a metal-ceramic bonded body. The obtained metal-ceramic bonded body had the aluminum nitride substrate, a titanium nitride layer (thickness: 0.6 µm), a brazing material layer (thickness: 6 µm) and the copper plate.

A resist ink (GIP-410 (trade name), manufactured by Goo Chemical Co., Ltd., viscosity: 10 mPa·s) was applied along a circuit pattern on the surface of copper plate by using an inkjet printing machine (manufactured by Nippon Bunkaseiko Co., Ltd., direct drawing system), and cured by using ultraviolet rays (irradiation dose: 300 mJ/m²) to thereby form a single-layer resist cured film. Here, an inkjet head the inkjet device had was of a piezo type; the heating temperature of the resist ink was 43°C; and the viscosity of the resist ink at this time was 10 mPa·s. This operation was repeated to thereby obtain a ceramic substrate having a two-layer resist cured film. The thickness of the two-layer resist cured film was 29 µm.

The titanium nitride layer, the brazing material layer and the copper plate of the obtained ceramic substrate excluding the portions thereof present underneath the two-layer resist film were etched by the following method.

First, a 3 mol/L hydrochloric acid and a 2 mol/L copper (II) chloride aqueous solution were mixed in 1:1 in terms of parts by mass to thereby obtain an etching solution whose temperature was about 45°C. By using this etching solution, the copper plate was etched.

Then, 10 parts by mass of sodium thiosulfate was added to 100 parts by mass of water and mixed to thereby obtain an etching solution whose temperature was about 40°C. By using this etching solution, the brazing material layer was etched.

Then, a 1 mol/L ammonium fluoride aqueous solution and a 35% hydrogen peroxide aqueous solution were mixed in 1:1 in terms of parts by mass to thereby obtain an etching solution whose temperature was about 35°C. By using this etching solution, the titanium nitride layer was etched.

Thereby, there was obtained a ceramic circuit board with a resist cured film whose copper plate had the predetermined circuit pattern.

Then, the ceramic circuit board with a resist cured film was dipped in a sodium hydroxide aqueous solution (concentration of sodium hydroxide: 2%) as a resist dissolving and stripping solution at 40°C for 5 min. This operation was once carried out to remove the two-layer resist cured film to thereby obtain a ceramic circuit board whose copper plate had the predetermined circuit pattern.

### [Example 2]

A ceramic circuit board with a resist cured film and a ceramic circuit board were obtained as in Example 1, except for three times repeating the formation of the single-layer resist cured film in Example 1 to thereby fabricate a three-layer resist cured film (thickness: 46 µm).

### [Example 3]

A ceramic circuit board with a resist cured film and a ceramic circuit board were obtained as in Example 1, except for four times repeating the formation of the single-layer resist cured film in Example 1 to thereby fabricate a four-layer resist cured film (thickness: 61 µm).

### [Comparative Example]

A ceramic circuit board with a resist cured film and a ceramic circuit board were obtained as in Example 1, except for making the number of times of the formation of the single-layer resist cured film in Example 1 to be once to thereby fabricate a single-layer resist cured film (thickness: 15 µm).

**[Table 1]**

| | Number of times of printing | Thickness of resist cured film | Uniformity of resist cured film | | Resistance to etching solution | Linearity of circuit pattern | | Removability of resist cured film | Overall judgment |
|---|---|---|---|---|---|---|---|---|---|
| | (times) | (µm) | (%) | judgment | judgment | (µm) | judgment | judgment | |
| Comparative Example 1 | 1 | 15 | 33.3 | CC | CC | 37 µm | CC | CC | CC |
| Example 1 | 2 | 29 | 138 | AA | AA | 18 µm | AA | AA | AA |
| Example 2 | 3 | 46 | 130 | AA | AA | 15 µm | AA | AA | AA |
| Example 3 | 4 | 61 | 14.7 | AA | AA | 15 µm | AA | CC | BB |

### Industrial Applicability

According to the present invention, there can efficiently be produced a ceramic circuit board with a resist cured film having a resist pattern high in resistance to an etching solution and high in precision by a method for producing a ceramic circuit board with a resist cured film by using an inkjet device. Hence, the board is suitable for semiconductor module substrates and the like, and by using obtained semiconductor module substrates, the size reduction of circuit boards and the output enhancement of power modules can be attained.

## Claims

1. A method for producing a ceramic circuit board with a resist cured film having a predetermined circuit pattern, comprising:
a step of providing a metal-ceramic bonded body having a ceramic substrate, a layer containing titanium nitride, a brazing material layer containing silver, and a metal plate having electroconductivity stacked in this order;
a step of applying a resist ink along the circuit pattern on the metal plate by an inkjet printing process, followed by curing to form a single-layer resist cured film, and repeating the formation twice or three times to thereby form a multilayer resist cured film having two or three layers and a total thickness of 30 µm or larger and 50 µm or smaller; and
a step of etching the layer containing titanium nitride, the brazing material layer containing silver and the metal plate excluding portions thereof present underneath the multilayer resist cured film by using an etching solution.

2. A method for producing a ceramic circuit board, comprising, after the etching step in the method for producing a ceramic circuit board with a resist cured film according to claim 1, a step of removing the multilayer resist cured film.

3. A ceramic circuit board with a resist cured film, comprising: a metal-ceramic bonded body having a ceramic substrate, a layer containing titanium nitride, a brazing material layer containing silver, and a metal plate having electroconductivity stacked in this order; and a multilayer resist cured film printed on the metal plate, wherein at least the metal plate and the multilayer resist cured film have a predetermined circuit pattern;
uniformity of a thickness of the multilayer resist cured film is 20% or lower, and wherein the multilayer resist cured film consists of two or three layers and has a total thickness of 30 µm or larger and 50 µm or smaller.

## Patentansprüche

1. Verfahren zum Herstellen einer Keramikleiterplatte mit einem gehärteten Resistfilm mit einer vorbestimmten Schaltkreisstruktur, das umfasst:
einen Schritt des Bereitstellens eines Metallkeramikverbundkörpers mit einem Keramiksubstrat, einer titannitridhaltigen Schicht, einer silberhaltigen Hartlötmaterialschicht und einer elektrisch leitfähigen Metallplatte, die in dieser Reihenfolge gestapelt sind;
einen Schritt des Auftragens einer Resisttinte entlang der Schaltkreisstruktur auf der Metallplatte mithilfe eines Tintenstrahldruckvorgangs, worauf das Härten unter Bildung eines einschichtigen gehärteten Resistfilms und das zwei- oder dreimalige Wiederholen der Bildung folgen, um einen mehrschichtigen gehärteten Resistfilm mit zwei oder drei Schichten und einer Gesamtdicke von 30 µm oder mehr und 50 µm oder weniger zu bilden; und
einen Schritt des Ätzens der titannitridhaltigen Schicht, der silberhaltigen Hartlötmaterialschicht und der Metallplatte unter Verwendung einer Ätzlösung, wobei Abschnitte davon ausgenommen sind, die unterhalb des mehrschichtigen gehärteten Resistfilms liegen.

2. Verfahren zum Herstellen einer Keramikleiterplatte, das nach dem Ätzschritt in dem Verfahren zum Herstellen einer Keramikleiterplatte mit einem gehärteten Resistfilm nach Anspruch 1 einen Schritt des Entfernens des mehrschichtigen gehärteten Resistfilms umfasst.

3. Keramikleiterplatte mit einem gehärteten Resistfilm, die umfasst: einen Metallkeramikverbundkörper mit einem Keramiksubstrat, einer titannitridhaltigen Schicht, einer silberhaltigen Hartlötmaterialschicht und einer elektrisch leitfähigen Metallplatte, die in dieser Reihenfolge gestapelt sind; und einem mehrschichtigen gehärteten Resistfilm, der auf die Metallplatte gedruckt ist, wobei zumindest die Metallplatte und der mehrschichtige gehärtete Metallfilm eine vorbestimmte Schaltkreisstruktur aufweisen;
eine Gleichmäßigkeit einer dicke des mehrschichtigen gehärteten Resistfilms 20 % oder weniger beträgt, und
wobei der mehrschichtige gehärtete Resistfilm aus zwei oder drei Schichten besteht und eine Gesamtdicke von 30 µm oder mehr und 50 µm oder weniger aufweist.

## Revendications

1. Procédé permettant de produire une carte de circuits imprimés en céramique à film durci de réserve ayant un motif de circuit prédéterminé, comprenant :
une étape consistant à fournir un corps lié en métal et céramique ayant un substrat en céramique, une couche contenant du nitrure de titane, une couche de matériau de brasage contenant de l'argent, et une plaque métallique à conductivité électrique, empilés dans cet ordre ;
une étape consistant à appliquer une encre de réserve le long du motif de circuit sur la plaque métallique par un processus d'impression à jet d'encre, suivie de la polymérisation pour former un film durci de réserve monocouche, et à répéter la formation deux ou trois fois afin de former ainsi un film durci de réserve multicouche ayant deux ou trois couches et une épaisseur totale de 30 µm ou plus, et de 50 µm ou moins ; et
une étape consistant à graver la couche contenant du nitrure de titane, la couche de matériau de brasage contenant de l'argent et la plaque métallique en excluant des parties de celles-ci présentes sous le film durci de réserve multicouche en utilisant une solution de gravure.

2. Procédé permettant de produire une carte de circuits imprimés en céramique, comprenant, après l'étape de gravure dans le procédé permettant de produire une carte de circuits imprimés en céramique à film durci de réserve selon la revendication 1, une étape consistant à retirer le film durci de réserve multicouche.

3. Carte de circuits imprimés en céramique à film durci de réserve, comprenant : un corps lié en métal et céramique ayant un substrat en céramique, une couche contenant du nitrure de titane, une couche de matériau de brasage contenant de l'argent, et une plaque métallique à conductivité électrique, empilés dans cet ordre ; et un film durci de réserve multicouche imprimé sur la plaque métallique, dans laquelle au moins la plaque métallique et le film durci de réserve multicouche présentent un motif de circuit prédéterminé ;
l'uniformité d'une épaisseur du film durci de réserve multicouche est de 20 % ou moins, et
dans laquelle le film durci de réserve multicouche est composé de deux ou de trois couches et présente une épaisseur totale de 30 µm ou plus et de 50 µm ou moins.
